# EUROPEAN PATENT APPLICATION

(11) **EP 2 151 861 A1**
(43) Date of publication of application: **10.02.2010**
(21) Application number: 08290758.5
(22) Date of filing: 06.08.2008
(51) Int. Cl.: H01L 21/762, H01L 21/324, H01L 21/20

(54) **Passivation of etched semiconductor structures**

(71) Applicant: S.O.I. TEC Silicon, 38190 Bernin (FR)
(72) Inventor: Faure, Bruce, 38000 Grenoble (FR); Guenard, Pascal, 38190 Froges (FR)
(74) Representative: Grünecker, Kinkeldey, Stockmair & Schwanhäusser Anwaltssozietät

(57) **Abstract**

The present invention relates to a method for passivation of a semiconductor structure, comprising the steps providing at least one first material layer; forming at least one second material layer that is to be patterned above the first material layer; forming a diffusion barrier layer between the at least one second material layer and the at least one first material layer thereby forming a multilayer stack and patterning, in particular, etching, the at least one second material layer down to but not completely through the diffusion barrier layer and without exposing portions of the at least one first material layer such that diffusion of material of the at least one first material layer through the diffusion barrier layer during a subsequent heat treatment of the multilayer stack is substantially prevented. The invention also relates to a method for passivation of a semiconductor structure, comprising the steps providing a multilayer stack comprising at least one buried layer formed below a second material layer, patterning, in particular, etching, the surface of the multilayer stack through the second material layer thereby exposing portions of the at least one buried layer and depositing a diffusion barrier layer at least on the exposed portions of the at least one buried layer such that diffusion of material of the at least one buried layer through the diffusion barrier layer during a subsequent heat treatment of the multilayer stack is substantially prevented.

## Description

### Field of Invention

The present invention relates to the passivation of etched portions of multilayer semiconductor structures like portions of buried layers exposed by etched trenches. In particular, the present invention relates to the passivation of a buried oxide layer comprising a compliant material layer used for the relaxation of a strained layer employed in the manufacture of semiconductor devices. More particularly, the passivated multilayer structures of the invention are used in electronic, optic, photovoltaic, optoelectronic field such as for LED, laser application.

### Background of the Invention

The technology of the manufacture of semiconductor devices comprises a great variety of etching processes used for forming trenches and similar structures in multilayer stacks of semiconductor and insulator materials. Integrated circuits are typically comprised of a large number of circuit elements located on a given chip area according to a specified circuit layout, wherein in complex circuits the field effect transistor represents one predominant circuit element. Generally, a plurality of process technologies are currently practiced, wherein for complex circuitry based on field effect transistors, such as microprocessors, storage chips, and the like, CMOS technology is currently one of the most promising approaches due to the superior characteristics in view of operating speed and/or power consumption and/or cost efficiency. During the fabrication of complex integrated circuits using CMOS technology, etching of trenches is commonly performed.

Among other procedural steps heat treatment of semiconductor component at different fabrication states has to be performed in various environments. Annealing processes that alter the microstructure of a (semiconductor) material causing changes in physical properties such as the conductivity, strength and hardness are commonly known. In the manufacture of small-sized transistors annealing may be included in an attempt to provide tensile or compressive strains to channel regions in order to enhance the performance of the transistors. In the context of compliant substances facilitating the employment of strained thin films heteroepitaxially grown on some seed substrate etched trenches can be provided for facilitating partial or complete relaxation of the strained thin films.

However, in trenches and similar etched structures the bottom and side surfaces include portions of material layers of the etched multilayer stack that are exposed to the environment after the etching process was completed. When such etched components are subject to some heat treatment constituents of these material layers can diffuse from the exposed portions out to the environment. The diffusion can severely affect the subsequent manufacturing steps and performance of finished semiconductor devices due to contamination of the annealing environment and the resulting contamination of both already formed layers and structures and those structures being formed during the annealing process.

In the manufacture of InGaNOS devices with relaxed strained InGaN layers, for example, the formation of strained material InGaN islands facilitates the relaxation of the strained layer. The formation of the islands is achieved by etching trenches separating portions of the strained layer. Relaxation is initiated by a heat treatment of the islands that are formed above some compliant layer, e.g., comprising borophosphosilicate glass (BPSG). The heat treatment results in a plastic deformation of the borophosphosilicate glass layer and some reflow thereby elastically relaxing the strained InGaN layer. During the heat treatment, however, boron and phosphorous atoms diffuse out of the portions of the borophosphosilicate glass material that are exposed at the walls and bottoms of the above-mentioned trenches. If the heat treatment is performed in an epitaxial reactor before or during the growth of an active layer, the diffused atoms contaminate the reactor atmosphere and the growing layer and thus affect performance of the built active layer.

It is thus a problem underlying the present invention to provide means to avoid diffusion of material portions of buried layers exposed by etched structures at the inner walls and the bottoms of trenches etched in multilayer stack arrangements.

### Description of the Invention

The above-mentioned problem is solved by the method for passivation of a semiconductor structure including the provision of a diffusion barrier layer according to claims 1 and 2. Thus, it is provided a method for passivation of a semiconductor structure, comprising the steps
providing at least one first material layer,
forming at least one second material layer that is to be patterned above the first material layer;
forming a diffusion barrier layer between the at least one second material layer and the at least one first material layer thereby forming a multilayer stack; and
patterning, in particular, etching, the at least one second material layer down to but not completely through the diffusion barrier layer and without exposing portions of the at least one first material layer such that diffusion of material of the at least one first material layer through the diffusion barrier layer during a subsequent heat treatment of the multilayer stack is substantially prevented.

The patterning of the second material layer can be performed by etching trenches or similar structures, for instance. Whereas the etching may remove material of the diffusion barrier layer in addition to parts of the second material layer, it is essential that the diffusion barrier layer is not completely etched through, i.e. the first material layer maintains completely covered by the diffusion barrier layer in the etched structures.

According to an alternative approach it is provided a method for passivation of a semiconductor structure, comprising the steps
providing a multilayer stack comprising at least one buried layer formed below a second material layer (in particular, a surface layer) of the multilayer stack;
patterning, in particular, etching, the surface of the multilayer stack through the second material layer thereby exposing portions of the at least one buried layer; and
depositing a diffusion barrier layer at least on the exposed portions of the at least one buried layer such that diffusion of material of the at least one buried layer through the diffusion barrier layer during a subsequent heat treatment of the multilayer stack is substantially prevented.

In both alternatives the material of the diffusion barrier layer is chosen such that in a subsequently performed heat treatment of the semiconductor structure no or substantially no diffusion of constituents (atom, molecules) of the first material layer from the etched structures is possible. The choice of the material of the diffusion barrier layer may particularly depend on the diffusion coefficients of the constituents of the first material layer and the temperatures involved in the heat treatment process. In particular, both above-mentioned methods may be supplemented by the step of performing a heat treatment of the multilayer stack.

By the provision of the diffusion barrier layer contamination of the environment during the heat treatment, e.g., an annealing atmosphere generated in some processing reactor, can be prevented. For example, in the case of annealing of the semiconductor structure in an epitaxial reactor used for epitaxial growth of a layer useful for the manufacture of a semiconductor device on the semiconductor structure contamination of the grown layer by diffused atoms of the first material layer is prevented.

The step of depositing the diffusion barrier layer may advantageously comprise depositing the diffusion barrier layer on side surfaces of the multilayer stack at which portions of the at least one buried layer are exposed. Thereby, not only diffusion of constituents of the first material layer from patterned trench-like structures (interspaces) can be prevented but also diffusion of these constituents from the side surfaces of the multilayer stack.

According to an embodiment the step of depositing the diffusion barrier layer comprises depositing the diffusion barrier layer on the patterned second material layer and the exposed portions of the at least one buried layer and on the above-mentioned side surfaces of the multilayer stack and at least portions of the diffusion barrier layer deposited on the material of the patterned second material layer are removed. The removal may be performed by selective etching CMP. If the patterning results in trenches separating islands the surface of the islands made of the material of the second material layer are etched (or treated otherwise) for removal of the material of the diffusion barrier layer previously deposited on the second material layer.

In particular, patterning of the second material layer may comprise etching trenches through the second material layer that extend to the at least one buried layer in which case portions of the diffusion barrier layer are removed such that the diffusion barrier layer only remains on the bottoms of the trenches and/or the walls of the trenches or such that the diffusion barrier layer only remains on the bottoms of the trenches and/or the walls and the side surfaces of the multilayer stack at which portions of the at least one buried layer are exposed.

The provision of the diffusion layer is particularly advantageous in the context of the formation of at least partially relaxed strained material layers that are used for epitaxy of layers used in electronic and opto-electronic applications, for instance. Accordingly, it is provided a method for passivation of a semiconductor structure comprising the steps
providing a first material layer that is a low-viscosity layer, in particular, a buried oxide layer or a buried polymer layer, made of a compliant material and, in particular, bonded to a support substrate;
forming at least one second material layer that is to be patterned above the first material layer to form a multilayer stack, wherein the second layer is a strained material layer, in particular, previously grown on a seed substrate and transferred to the support substrate by means of the first material layer;
forming a diffusion barrier layer between the at least one second material layer and the at least one first material layer; and
patterning the at least one second material layer down to but not completely through the diffusion barrier layer and without exposing portions of the at least one first material layer such that diffusion of material of the at least one first material layer through the diffusion barrier layer during a subsequent heat treatment of the multilayer stack is substantially prevented, wherein
the patterning comprises etching trenches in the strained material layer to form strained material islands; and
heat treatment is performed in order to at least partly relax the strained material islands, wherein diffusion of compliant material out of the multilayer stack is substantially prevented by the diffusion barrier layer.

In the alternative method as claimed in claim 2 comprising providing a multilayer stack comprising at least one buried layer formed below a second material layer of the multilayer stack and patterning the surface of the multilayer stack through the second material layer thereby exposing portions of at least one of the buried layers according to an embodiment
the at least one buried layer is a low-viscosity layer, in particular, a buried oxide layer, made of a compliant material and it is, in particular, bonded to a support substrate;
the second material layer is a strained material layer, in particular, previously grown on a seed substrate and transferred to the support substrate by means of the first material layer;
patterning comprises etching trenches in the strained material layer to form strained material islands; and
depositing a diffusion barrier layer at least on the exposed portions of the at least one buried layer, etching of the barrier layer on the strained pattern surface.

Moreover, heat treatment is performed to at least partly relax the strained material islands, wherein diffusion of compliant material out of the multilayer stack is substantially prevented by the diffusion barrier.

In particular, in the context of the manufacture of InGaNOS structures that are useful for the production of LEDs and solar cells, for instance, heat treatment for partial or complete relaxation of strained InGaN layers that are heteroepitaxially grown on a GaN seed layer and transferred to a support substrate is a crucial step in the process line. The quality of epitaxially formed layers on the surface of the relaxed strained InGaN layers can be heavily affected by diffused constituents of the compliant material used for the relaxation. The provision of the diffusion barrier layer in accordance with the present invention solves the problems caused by such diffusion.

According to another embodiment, the diffusion barrier may also be deposited after the relaxation step of the strained material islands. The diffusion barrier is then etched to expose the surface of the at least partially relaxed strained islands without exposing portions of the compliant layer such that no diffusion of elements occurs during subsequent heat treatment as epitaxy of active layers performed on the islands.

It should be noted that InGaN represents only one example for the material of the strained material layer. In fact, the strained material layer may, for instance, comprise or consist of a III/N material chosen from a binary, ternary quaternary alloy.

The above-mentioned low-viscosity layer (termed low-viscosity in order to indicate compliance and deformation ability, that is for example material with a glass transition temperature between 500 and 950°C. Most of undoped dioxide materials have for example a glass transition temperature above 1200°C) can, in particular, be a buried oxide layer that can comprise or consist of a borophosphosilicate glass or an SiO₂ - compound comprising boron or phosphorous or a buried polymer layer. A reliable relaxation of the strained material islands made of InGaN can be achieved when the compliant material is a typical borophosphosilicate glass comprising about 4.5 % of weight boron and 2 % of weight phosphorous. Experiments have proven that diffusion of boron and/or phosphorous can effectively be suppressed when the diffusion barrier layer comprises or consists of silicon dioxide SiO2 (with no boron or phosphorus species) or SiN in particular SiₓN_{y}:H or Si₃N₄. Less than 4 % of weight boron is preferred in order to guarantee a sufficient mechanical rigidity at temperatures (about 800 °C) involved in epitaxy on the relaxed strained material. According to an example, the diffusion barrier layer (e.g., a diffusion barrier layer comprising or consisting of SiO2 or SiN in particular SiₓN_{y}:H or Si₃N₄) is deposited at a thickness of 10 nm to 3 micrometer, in particular, 10 nm to 200 nm, in order to prevent diffusion of constituents of the first material layer, in particular, of boron and/or phosphorous of a borophosphosilicate glass or an SiO₂ - compound comprising boron or phosphorous.

As already mentioned the herein disclosed methods are particularly useful for the manufacture of semiconductor devices comprising the epitaxial growth layers on at least partially relaxed strained material layers. Thus, it is provided a method for the manufacture of a semiconductor device, comprising the passivation of a semiconductor structure formation according to one of the above examples, and further comprising epitaxially or homoepitaxially growing a material layer on the formed at least partially relaxed strained material, in particular, at least partially relaxed strained material islands.

The at least partially relaxed strained material may be transferred to another substrate before epitaxy. For example, in the case of partially or completely relaxed strained InGaN islands thereby a free Ga face is obtained on which (homo)epitaxially can easily be carried out. To avoid this double-transfer to expose the Ga face (i.e. the III-element face) it is also possible to transfer directly the strained InGaN layer from the N-polarity face of a donor substrate so that to bond the N-face onto the substrate and to free the Ga face of the InGaN layer for subsequent steps.

The present invention, furthermore, provides a semiconductor structure comprising a multilayer stack comprising a buried layer formed below a second material layer, wherein both layers are patterned and a diffusion barrier layer deposited at least on the portions of the at least one buried layer exposed by the patterning. Moreover, that kind of semiconductor structure is provided wherein the second material layer is a stained material layer after heat treatment has been performed for at least partial relaxation of the patterned strained material layer. Furthermore, a semiconductor structure comprising an at least partly relaxed strained material layer above a patterned buried layer and a diffusion barrier layer deposited at least on the portions of the at least one buried layer exposed by the patterning and, in addition, comprising active layer(s) on the at least partially relaxed strained material, in particular LED, laser or photovoltaic device layer, is provided herein.

Additional features and advantages of the present invention will be described with reference to the drawings. In the description, reference is made to the accompanying figures that are meant to illustrate preferred embodiments of the invention. It is understood that such embodiments do not represent the full scope of the invention.

Figure 1 illustrates an example of the inventive method comprising the steps of the formation of strained material islands above a diffusion barrier layer.

Figure 2 illustrates an example of the inventive method comprising the steps of the formation of strained material islands and the deposit of a diffusion barrier layer.

Figure 3 illustrates another example of the inventive method comprising the steps of the formation of strained material islands and the deposit of a diffusion barrier layer.

In the following, examples for preventing diffusion of constituents of a compliant material layer provided for partial or complete relaxation of a strained material layer during heat treatment according to the present invention are explained. In view of the description above the skilled person will appreciate that generalization to any multilayer structure is straightforward.

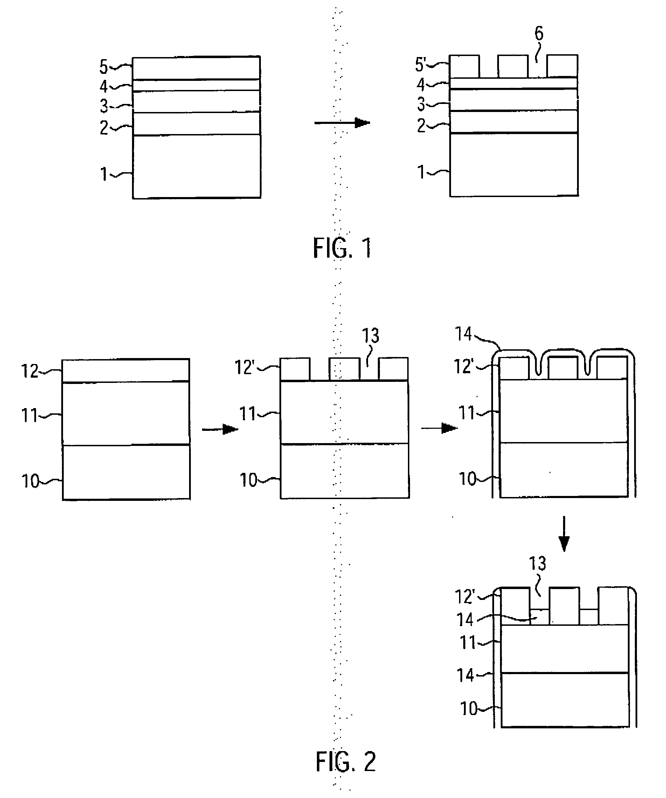

Figure 1 shows an example of a multilayer stack formed in accordance with the herein disclosed method for passivation of a semiconductor structure. The multilayer stack comprises a support substrate 1, a first borophosphosilicate glass layer 2, a second borophosphosilicate glass layer 3, a diffusion barrier layer 4 and a strained InGaN layer 5 with a free (upper) Ga face. In some detail, this multilayer stack was formed as follows. The strained InGaN layer 5 is transferred from a N-face polarity InGaN donor substrate such that after transfer on the support substrate 1 the free face of the InGaN layer 5 has the Ga polarity. The diffusion barrier layer 4 was already deposited on the N face of InGaN layer 5 and subsequently the second borophosphosilicate glass layer 3 was deposited atop of the diffusion barrier layer 4. In the present example this diffusion barrier layer 4 is an Si3N4 - layer.

The first borophosphosilicate glass layer 2 is deposited on the support substrate 1 for bonding to the second borophosphosilicate glass layer 3 and transfer of the strained InGaN layer 5 from the source substrate to the support substrate 1. The structure shown in Figure 1 is obtained after this transfer, i.e. detachment of the source substrate. After the transfer the strained InGaN layer 5 is patterned by etching trenches 6 thereby forming strained InGaN islands 5'. The trenches are etched down to but not completely through the diffusion barrier layer 4. Thus, the first borophosphosilicate glass layer 2 maintains covered by material of the second borophosphosilicate glass layer 3. The etching can, e.g., be stopped as soon as material of the diffusion barrier layer 4 is detected in the etching atmosphere or a significant change in the etching rate is determined.

After the patterning of the strained InGaN layer 5 the multilayer stack is subject to heat treatment resulting in some reflow (plastic deformation) of at least the second borophosphosilicate glass layer 3 and thereby relaxation of the strained InGaN islands 5'. Due to the provision of the diffusion barrier layer 4, no constituents of the first and second borophosphosilicate glass layer 2 and 3 diffuse in the annealing atmosphere generate for the heat treatment process and, thus, no contamination of subsequently grown layers is caused.

Whereas this example of the inventive passivation method has the advantage of fast and simple processing the diffusion barrier layer 4 provided between the compliant second borophosphosilicate glass layer 3 and the strained InGaN islands 5' may affect the relaxation process. In particular, the diffusion barrier layer 4 may hinder complete relaxation of the strained InGaN islands 5'. An alternative method is described with reference to Figure 2.

As shown in Figure 2 a multilayer stack comprising a support substrate 10, a phosphosilicate glass layer 11 and a strained InGaN layer 12 is provided. This stack also results from the transfer of the strained InGaN layer 12 from some seed substrate to the support substrate 10. The strained InGaN layer 12 is patterned by etching trenches 13 thereby forming strained InGaN islands 12'. The trenches may also be formed in the compliant layer 11. Subsequently, a diffusion barrier layer 14 of Si3N4 is deposited on the strained InGaN islands 12', in the trenches 13, at least at the trench walls of the compliant layer 11 and at the side surfaces on the multilayer stack.

Next, a photolithography step is performed in order to partly remove the material of the diffusion barrier layer 14 such that this diffusion barrier layer 14 is maintained on the side surfaces of the multilayer stack, at the trench walls of the compliant layer 11 and in the lower part of the trenches 13 as shown in Figure 2. Whereas this example includes the additional step of photolithography, it provides the advantage that relaxation of the strained InGaN islands 12' by subsequent heat treatment is not significantly hindered by the diffusion barrier layer 14, in particular, since the strained InGaN islands 12' are in direct contact with the compliant borophosphosilicate glass layer 11 that causes the relaxation by reflow during the heat treatment. Moreover, relaxation of the strained InGaN islands 12' is improved by removing the diffusion barrier layer 14 from the upper surface of these islands. Similar to the example described with reference to Figure 1 diffusion of constituents of the borophosphosilicate glass layer 11, in particular, of boron or phosphorous atoms, during the heat treatment is prevented by the diffusion barrier layer 14.

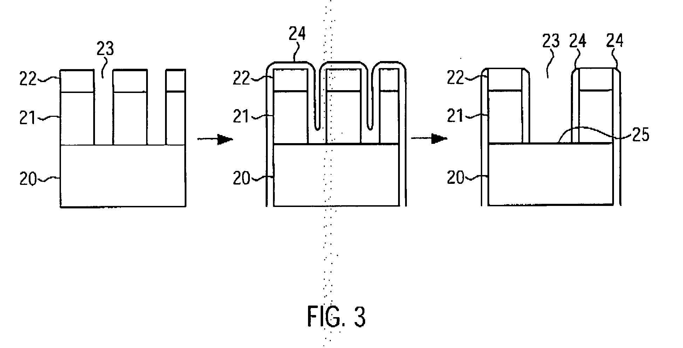

Figure 3 illustrates another example of the herein disclosed passivation method. A stack comprising a support substrate 20 and a borophosphosilicate glass layer 21 as well as a strained InGaN layer 22 similar to the stack shown in Figure 2 is provided and trenches 23 are etched through the borophosphosilicate glass layer 21 and the strained InGaN layer 22. A diffusion barrier layer 24 consisting of Si3N4 is deposited on the remaining borophosphosilicate glass layer 21 and strained InGaN layer 22, in the trenches 23 and at the side surfaces of the multilayer stack as shown in Figure 3. Subsequently, anisotropic dry etching is performed in order to remove material of the diffusion barrier layer 24 from the top of ihe remaining parts of the patterned strained InGaN layer 22 and from the bottoms 23 of the trenches 23. The inner walls of the trenches remain covered by the diffusion barrier layer 24. Since the etching of trenches was only stopped at the support substrate 20, no diffusion of boron or phosphorous atoms during subsequent annealing for relaxation of the strained InGaN layer 22 occurs.

In the examples described above with reference to Figures 1 to 3, an SiO2 layer or undoped silicon glass of thickness of about 50 nm, for instance, may be deposited on the InGaN layer before the deposit of the borophosphosilicate glass in order to improve adherence of the borophosphosilicate glass layer to the InGaN layer. The borophosphosilicate glass layers of Figure 1 or the borophosphosilicate glass layer of Figure 2 and 3 may have a thickness of about 500 nm and may comprise 4 - 5 % of weight boron and 2 % of weight of phosphorous. The InGaN layer may have a thickness of about 100 nm and may comprise 5 - 7 % of molar mass indium.

The deposition of the diffusion barrier layer (see reference sign 4 in Figure 1 and reference signs 14 and 24 in Figures 2 and 3, respectively) at a thickness of, e.g., 10 to 200 nm, can be performed by any deposition method known in the art, for instance, by low-pressure plasma enhanced chemical vapor deposition (LPCVD) or plasma enhanced chemical vapor deposition from metal organic compounds (PECVD).

The at least partially relaxed strained (InGaN) islands can be used for epitaxy of a layer that is useful for the formation of a semiconductor device or solar cells. The at least partially relaxed strained islands may be transferred to another substrate such that they show a free Ga face on which (homo)epitaxy, e.g., of an InGaN layer, can be carried out. Alternatively, the face of nitrogen polarity of the heteroepitaxially grown strained InGaN layer may directly be transferred to the support substrate to obtain a relaxed free face of gallium polarity for the subsequent epitaxy process. Obviously, an InGaN structure with a free face of gallium polarity might also be obtained, if it is desired.

It should be noted that trenches might be formed through the strained layer and the compliant layer down to the support substrate without the formation of any diffusion barrier in order to decrease the out diffusion. In this case, out diffusion can only occur at the trench walls, since the bottoms of the trenches are free of the material of the compliant layer. However, provision of the diffusion barrier layer represents the most efficient way of preventing out diffusion of material portions of buried layers.

All previously discussed embodiments are not intended as limitations but serve as examples illustrating features and advantages of the invention. It is to be understood that some or all of the above described features can also be combined in different ways.

## Claims

1. Method for passivation of a semiconductor structure, comprising the steps
providing at least one first material layer;
forming at least one second material layer that is to be patterned above the first material layer;
forming a diffusion barrier layer between the at least one second material layer and the at least one first material layer thereby forming a multilayer stack; and
patterning, in particular, etching, the at least one second material layer down to but not completely through the diffusion barrier layer and without exposing portions of the at least one first material layer such that diffusion of material of the at least one first material layer through the diffusion barrier layer during a subsequent heat treatment of the multilayer stack is substantially prevented.

2. Method for passivation of a semiconductor structure, comprising the steps
providing a multilayer stack comprising at least one buried layer formed below a second material layer;
patterning, in particular, etching, the surface of the multilayer stack through the second material layer thereby exposing portions of the at least one buried layer; and
depositing a diffusion barrier layer at least on the exposed portions of the at least one buried layer such that diffusion of material of the at least one buried layer through the diffusion barrier layer during a subsequent heat treatment of the multilayer stack is substantially prevented.

3. Method according to claim 2, wherein the step of depositing the diffusion barrier layer comprises depositing the diffusion barrier layer on the patterned second material layer and the exposed portions of the at least one buried layer; further comprising
comprising removing at least portions of the diffusion barrier layer deposited on the material of the patterned second material layer.

4. Method according to claim 3, wherein patterning of the second material layer comprises etching trenches through the second material layer that extend to the at least one buried layer and wherein portions of the diffusion barrier layer are removed such that the diffusion barrier layer only remains on the bottoms of the trenches and/or the walls of the trenches and the side surfaces of the multilayer stack at which portions of the at least one buried layer are exposed.

5. Method according to one of the preceding claims, wherein the step of depositing the diffusion barrier layer comprises depositing the diffusion barrier layer on side surfaces of the multilayer stack at which portions of the at least one buried layer are exposed.

6. Method according to claim 1, wherein
the first material layer is a low-viscosity layer and it is, in particular, bonded to a support substrate;
the second material layer is a strained material layer, in particular, previously grown on a seed substrate and transferred to the support substrate by means of the first material layer;
the patterning comprises etching trenches in the strained material layer to form strained material islands; and
heat treatment is performed in order to at least partly relax the strained material islands.

7. Method according to claim 6, wherein the heat treatment is perfomed before deposition of the diffusion barrier layer,

8. Method according to one of the claims 2 to 5,
wherein the at least one buried layer is a low-viscosity layer comprising a compliant material and it is, in particular, bonded to a support substrate;
the second material layer is a strained material layer, in particular, previously grown on a seed substrate and transferred to the support substrate by means of the first material layer;
patterning comprises etching trenches in the strained material layer to form strained material islands; and
heat treatment is performed to at least partly relax the strained material islands, wherein diffusion of compliant material out of the multilayer stack is substantially prevented by the diffusion barrier.

9. Method according to one of the claims 6, 7 and 8, wherein the low-viscosity layer is a buried oxide layer and comprises or consists of a borophosphosilicate glass or an SiO₂- compound comprising boron or phosphorous.

10. Method according to claim 9, wherein the compliant material is a borophosphosilicate glass, in particular, comprising 4.5 % of weight boron and 2 % of weight phosphorous.

11. Method according to claim 9 or 10, wherein the diffusion barrier layer comprises or consists of SiN or SiO₂.

12. Method according to one of the claims 6 to 11, wherein the strained material layer comprises or consists of a III/N material chosen from a binary, ternary quaternary alloy.

13. Method according to claim 12, wherein the strained material layer comprises or consists of InGaN.

14. Method according to one of the claims 6 to 13, wherein the strained material layer is transferred from a massive III/N material substrate and the exposed layer face polarity is the III element - face.

15. Method according to one of the preceding claims, wherein the diffusion barrier layer is deposited at a thickness of 10 nm to 3 micrometer, in particular, 10 nm to 200 nm.

16. Method for the manufacture of a semiconductor device, comprising the passivation of a semiconductor structure formation according to one of the claims 6 to 14, and further comprising epitaxially growing a material layer on the formed at least partially relaxed strained material, in particular, at least partially relaxed strained material islands.

17. Method according to the preceding claim comprising formation of at least one active layer on the at least partially relaxed strained material, in particular LED, laser or photovoltaic device layers.
